## Europäisches Patentamt
## European Patent Office
## Office européen des brevets

(19)

(11) Numéro de publication: **0 216 657 B1**

(12) # FASCICULE DE BREVET EUROPEEN

(45) Date de publication du fascicule du brevet:
01.08.90

(51) Int. Cl.⁵: **G01N 24/08**

(21) Numéro de dépôt: 86401788.4

(22) Date de dépôt: 08.08.86

(54) Procédé de modulation de l'effet de la vitesse des parties mobiles d'un corps dans une mesure de densité par résonance magnétique nucléaire.

(30) Priorité: 13.08.85 FR 8512352
12.12.85 US 808049

(43) Date de publication de la demande:
01.04.87 Bulletin 87/14

(45) Mention de la délivrance du brevet:
01.08.90 Bulletin 90/31

(84) Etats contractants désignés:
DE FR GB NL

(56) Documents cités:
EP-A- 0 115 642
EP-A- 0 142 343

RADIOLOGY,
vol. 154, no. 2, février 1985, pages 433-444, Easton, US;
P.R. MORAN et al.: "Verification and evaluation of internal flow and motion"
PHYSICS IN MEDICINE AND BIOLOGY,
vol. 29, no. 7, juillet 1984, pages 891-895, Bristol, GB;
T.W. REDPATH et al.: "A new method of NMR flow imaging"
MEDICAL PHYSICS,
vol. 12, no. 1, janvier/février 1985, pages 59-64, New York, US; M.O'DONNELL: "NMR blood flow imaging using multiecho, phase contrast sequences"

(73) Titulaire: GENERAL ELECTRIC CGR S.A., 100, rue Camille-Desmoulins, F-92130 Issy les Moulineaux(FR)

(72) Inventeur: Le Roux, Patrick, THOMSON - CSF SCPI 19, avenue de Messine, F-75008 Paris(FR)

(74) Mandataire: Ballot, Paul Denis Jacques et al, Cabinet Ballot-Schmit 7, rue le Sueur, F-75116 Paris(FR)

**Description**

La présente invention a pour objet un procédé de modulation de l'effet de la vitesse des parties mobiles d'un corps dans une mesure de densité par résonance magnétique nucléaire (RMN) ainsi que la mise en œuvre du procédé pour en déduire la vitesse des parties mobiles concernées. L'invention trouve son application particulièrement dans le domaine médical où les corps examinés sont des corps humains et où les parties mobiles sont des cellules du sang circulant dans des veines ou des artères ou des organes mobiles tels que le muscle cardiaque. Dans cette application, l'invention peut même plus particulièrement être mise en œuvre avec un procédé d'imagerie pour donner une image représentative de la répartition des vitesses des parties mobiles dans une coupe du corps examiné.

En effet, l'imagerie par résonance magnétique nucléaire se développe principalement comme moyen de diagnostic médical. Elle permet la visualisation des structures internes tissulaires avec un contraste et une résolution jamais atteints simultanément par les autres procédés d'imagerie. Pour obtenir une image par résonance magnétique nucléaire d'une coupe d'un corps avec différenciation des caractéristiques tissulaires de ce corps, on utilise la propriété qu'ont certaines particules, comme les protons, d'orienter leur moment magnétique en acquérant de l'énergie lorsqu'ils sont placés dans un champ magnétique principal constant $B_0$. Une zone particulière d'un corps contenant des particules présente alors un moment magnétique global que l'on peut faire basculer selon une orientation donnée, perpendiculaire ou parallèle au champ $B_0$, en induisant une résonance par émission d'un champ magnétique radiofréquence perpendiculaire au champ principal.

Toutes les particules possédant alors un moment magnétique, tournant à une vitesse de précession dite de Larmor, tendent à retrouver l'orientation initiale parallèle à $B_0$ en émettant un signal radiofréquence à la fréquence de résonance caractéristique de $B_0$ et de la particule. Ce signal peut être capté par une antenne de réception. La durée de retour à l'équilibre du moment magnétique global d'une région considérée et la décroissance du signal dépendent de deux facteurs importants : l'interaction spin-réseau et l'interaction spin-spin des particules avec la matière environnante. Ces deux facteurs conduisent à la définition de deux temps de relaxation caractéristiques du tissu et dits respectivement $T_1$ et $T_2$. Une région considérée d'un objet émet donc un signal dont l'intensité dépend de $T_1$, de $T_2$, de la densité de particules dans la région, et du temps qui s'est écoulé depuis l'excitation radiofréquence.

Si le champ orienteur est parfaitement homogène, des particules mobiles dans une région considérée émettent en réponse un signal identique à celui des particules fixes de cette région. Par contre si le champ orienteur n'est pas homogène, ou plus généralement si pour diverses raisons (en particulier pour faire de l'imagerie) on applique pendant ou après l'excitation magnétique radiofréquence un champ magnétique perturbateur, présentant un gradient d'intensité, on peut montrer que les contributions apportées par les particules mobiles dans le signal global émis sont affectées d'une composante de phase dépendant justement de leur vitesse. Ceci peut se comprendre simplement : le signal de résonance émis vibre à une fréquence $f_0$ qui dépend de l'intensité du champ magnétique orientateur $B_0$ et d'un rapport dit gyromagnétique $\gamma$ caractéristique du milieu examiné. Toutes variations de l'intensité du champ $B_0$ provoquent donc une variation correspondante de la fréquence de résonance. En conséquence, une particule fixe soumise, après l'excitation radiofréquence, pendant un premier temps au champ $B_0$ résonne à une fréquence $f_0$, dans un deuxième temps, soumise à un champ plus fort $B_0 + \Delta B_0$, elle résonne à une fréquence plus élevée $f_0 + \Delta f_0$. Dans un troisième temps à nouveau soumise au champ $B_0$ elle vibre à nouveau à la fréquence $f_0$. Au cours du troisième temps le signal émis est alors déphasé par rapport à sa phase pendant le premier temps. Ce déphasage est proportionnel à l'amplitude de la perturbation $\Delta B_0$ et à la durée de cette perturbation. Si toutes les particules du milieu sont fixes ou, si la perturbation qui a atteint dans le temps tout le milieu n'a pas de gradient, il en résulte simplement que le signal global émis est seulement retardé.

Il en va différemment par contre pour les particules animées d'une certaine vitesse quand la perturbation présente un gradient. Celles-ci fréquentent au cours des trois périodes (du fait de leur vitesse de déplacement pendant ces périodes) des régions de l'espace où les champs orientateurs et perturbateurs sont différents. Ils sont différents respectivement du fait de l'existence d'inhomogénéités ou du fait de l'existence de gradients. En conséquence la contribution des particules mobiles dans le signal se trouve apportée avec une phase qui dépend non seulement de l'amplitude des perturbations rencontrées (comme pour les particules fixes) mais aussi de la variation d'amplitude de ces perturbations le long du parcours qu'elles ont emprunté. Cette variation qui constitue le gradient est géographiquement imposée. En conséquence, le déphasage du signal des particules mobiles dépend alors de leur vitesse puisque elles fréquentent d'autant plus de régions de l'espace que leur vitesse est grande. Si les vitesses de déplacement, les inhomogénéités, ou les gradients de champ sont trop grands, les phases des différentes contributions peuvent en être à ce point affectées qu'elles finissent par s'opposer. Dans ce cas, ces contributions s'annulent mutuellement et le signal global résultant est moins fort. Dans la pratique cet effet est tel qu'il donne souvent l'illusion qu'il n'y a pas de matière dans un corps à l'endroit où circulent des particules mobiles.

Pour faire apparaître l'existence des particules mobiles et pour en mesurer les caractéristiques, la densité et éventuellement la vitesse de déplacement, on peut procéder selon une méthode décrite par E.L.HAHN en Février 1960 dans le Journal of GEOPHYSICAL RESEARCH, volume 65, n° 2, pages 776 et suivantes. L'auteur y suggère de soumettre le milieu étudié à une séquence d'un gradient particulier : à le coder. Le principe de ce codage consiste à appliquer après le basculement de l'impulsion radiofréquence, un gradient dit bipolaire selon l'axe d'une composante de vitesse que l'on veut reconnaître. Un gradient bipolaire est tel que son intégrale temporelle, du temps correspondant au début de l'impulsion radiofréquence au temps correspondant au début de la mesure, est nulle. Le moment magnétique de spin d'une particule immobile ne subit dans ce cas qu'un déphasage global nul. En effet le déphasage subit pendant l'application d'une première partie du gradient bipolaire est compensé par l'application de la deuxième partie de ce gradient bipolaire. Par contre une particule mobile, ayant une vitesse positive suivant l'axe du gradient, subit lors de la deuxième partie de l'impulsion un déphasage plus important en valeur absolue que pendant la première partie parce qu'elle fréquente, pendant cette deuxième partie, une région de l'espace où, du fait du gradient, le champ magnétique perturbateur est plus fort. En comparant une mesure relevée avec un tel gradient bipolaire à une mesure relevée sans qu'il ait été appliqué, on peut en déduire la vitesse et le nombre des particules mobiles.

Quels que soient les buts poursuivis, mesure simple ou mesure avec image, et quelles que soient les procédures retenues, la sensibilité du phénomène de vitesse au champ magnétique perturbateur appliqué est telle, qu'en définitive, la mise en évidence des phénomènes de déplacement n'est possible que tant que les vitesses maximales sont inférieures à une limite. En particulier en imagerie, selon que la composante de vitesse à mettre en évidence est parallèle ou perpendiculaire au plan de la coupe imagée, la sensibilité des machines de RMN est actuellement de l'ordre de 1 radian/(cm/s) à 0,2 rd/(cm/s). Ceci signifie qu'une particule qui se déplace de 1 cm par seconde dans le plan de la coupe contribue au signal global émis avec un déphasage de 1 radian par rapport aux contributions émises par les particules fixes. Dans le corps humain une vitesse nominale de circulation du sang de 50 cm/s est couramment atteinte, voire même de plusieurs mètres par seconde dans le cœur. De plus la distribution des vitesses dans un vaisseau est étalée entre zéro, sur les bords du vaisseau, et la vitesse nominale au centre du vaisseau. Donc chaque particule d'un vaisseau contribue au signal avec un déphasage qui peut valoir de 0 à 50 radians ! Sachant que des contributions déphasées de Π radians s'opposent mutuellement, le signal résultant est nul : cela revient à prendre la valeur moyenne d'un signal sinusoïdal sur plusieurs périodes. A titre d'exemple, Paul R. Moran dans un article de la revue Radiology du RSNA de 1985, 154, pages 433 à 441, fait état d'une mesure de vitesse moyenne égale à 0,6 cm par seconde et correspondant à un déphasage d'environ 90°. Au-delà de cette limite, la sensibilité des machines est trop forte et les vitesses ne sont plus mesurables.

L'invention a pour objet de mettre en évidence l'effet de la vitesse des parties mobiles d'un corps en modifiant la sensibilité des machines d'une manière particulière. La modification de sensibilité, tout en ne modifiant d'aucune manière les signaux émis par les parties fixes, peut avoir pour effet d'annuler la part de déphasage dû à la vitesse. Les particules en mouvement contribuent alors au signal global comme si elles étaient fixes. Le procédé de l'invention permet par ailleurs, plutôt que de tout annuler, de moduler l'effet de la vitesse. En faisant deux mesures, avec des caractéristiques de modulation différentes, et en comparant les deux mesures, on peut supprimer l'incidence des parties fixes pour ne laisser apparaître que celle des parties mobiles. Dans cette comparaison les parties mobiles apparaissent pondérées par les caractéristiques de modulation des deux expérimentations. Dans l'invention ces caractéristiques sont calculables et l'effet de la vitesse peut être quantifié.

Le principe énoncé dans le procédé de l'invention est très général. Il n'est pas cantonné à une application, plus complète, d'imagerie. Il peut en particulier être mis en œuvre avec des spectromètres de masse. Par ailleurs, il s'applique quelles que soient les procédures d'excitation radiofréquence retenues : procédures connues souvent sous leurs noms anglo-saxon de saturation recovery, inversion recovery, double saturation recovery, saturation recovery - inversion recovery, spin-echo, etc. De même l'invention, dans le cadre de l'imagerie, est applicable quelle que soit la procédure d'imagerie retenue : par exemple que celle-ci soit une méthode de retroprojection de type P.C. Lauterbur, une méthode par transformée de Fourier de type 3DFT ou 2DFT mise au point par A. Kumar et R.R. Ernst ou sa variante connue sous le nom de spin warp (c'est dans cette seconde méthode que l'invention sera décrite), une méthode d'imagerie des volumes sensibles mise au point par W.F. Hinshaw, ou encore une méthode d'acquisition rapide mise au point par P. Mansfield et plus connue sous le nom de "Echo-planar", etc. En effet, dans toutes les situations impliquées par ces procédures, la modulation objet de l'invention est possible puisqu'elle consiste à modifier les champs magnétiques perturbateurs (les gradients de champ) en leur adjoignant des champs magnétiques compensateurs d'allure semblable, et dont les caractéristiques de forme, de durée, et d'amplitude dépendent de ces champs magnétique perturbateurs.

Il est connu par la demande de brevet EP-A 0 142 343 un procédé de modulation de l'effet de la vitesse des parties mobiles d'un corps dans une mesure de densité par résonance magnétique nucléaire, mesure pour laquelle, conformément à l'art antérieur,
- on soumet le corps à un champ magnétique orientateur et constant pour orienter dans une direction unique des moments magnétiques de spin du corps,
- on fait subir à ce corps une excitation magnétique grâce à une première impulsion de radiofréquence en présence de et/ou suivie de l'application d'une séquence d'un champ magnétique perturbateur,
- et on relève un signal de résonance magnétique émis en réponse par le corps.

Ce procédé est particulier en ce qu'on module l'effet de la vitesse des parties mobiles du corps créé par la séquence du champ perturbateur, par l'application, avant le relevé, d'une séquence d'un champ de colage par gradients, dont l'intégrale calculée sur sa durée est nulle, et dont l'historique et la valeur sont fonction de l'historique et de la valeur du champ perturbateur. Ces gradients sont déterminés en rendant le premier moment de leur séquence égal à zéro par rapport à l'instant d'application de la première impulsion de radiofréquence.

Dans l'invention, pour simplifier la détermination de l'intègrale, et rendre la mise en œuvre de ce procédé plus pratique, on choisit de déterminer a priori en forme, en durée, et en position les impulsions de gradient de compensation.

L'invention concerne également une mise en œuvre de ce procédé, caractérisée en ce qu'on le met une première fois en œuvre pour compenser l'effet de la vitesse, et une autre fois en œuvre en modifiant une ou plusieurs des caractéristiques du champ magnétique compensateur et en ce qu'on compare les mesures obtenues dans les deux mises en œuvre pour en déduire la vitesse des parties mobiles concernées.

L'invention sera mieux comprise à la lecture de la description qui suit et à l'examen des figures qui l'accompagnent. Comme cela a été évoqué plus haut cette description et ces dessins ne sont donnés qu'à titre indicatif et nullement limitatif de l'invention. En particulier l'invention n'est décrite que dans une application d'imagerie. Sur les figures les mêmes repères désignent les mêmes éléments. Elles montrent:

- figure 1 : une machine pour la mise en œuvre du procédé selon l'invention ;
- figure 2 : des diagrammes temporels de signaux radiofréquence d'excitation, de signaux de champ magnétique perturbateur, et de signaux relevés dans une mesure particulière comportant une imagerie de type 2DFT d'une coupe d'un corps sous examen ;
- figures 3a et 3b : des diagrammes temporels de déphasages résultant, après application de séquences de champs magnétiques perturbateurs, entre les contributions émises par des particules fixes et des particules en mouvement ;
- figure 4 : une représentation schématique de la réponse d'une partie d'un milieu dont les particules sont en déplacement selon que ce déplacement est parallèle ou perpendiculaire à un plan de coupe imagé.

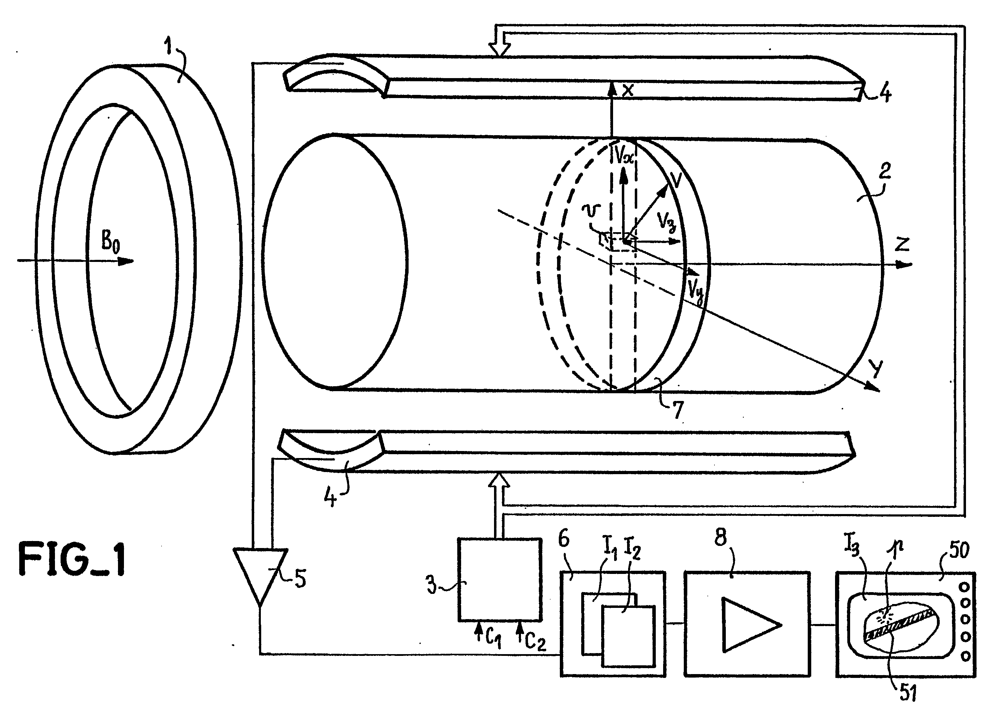

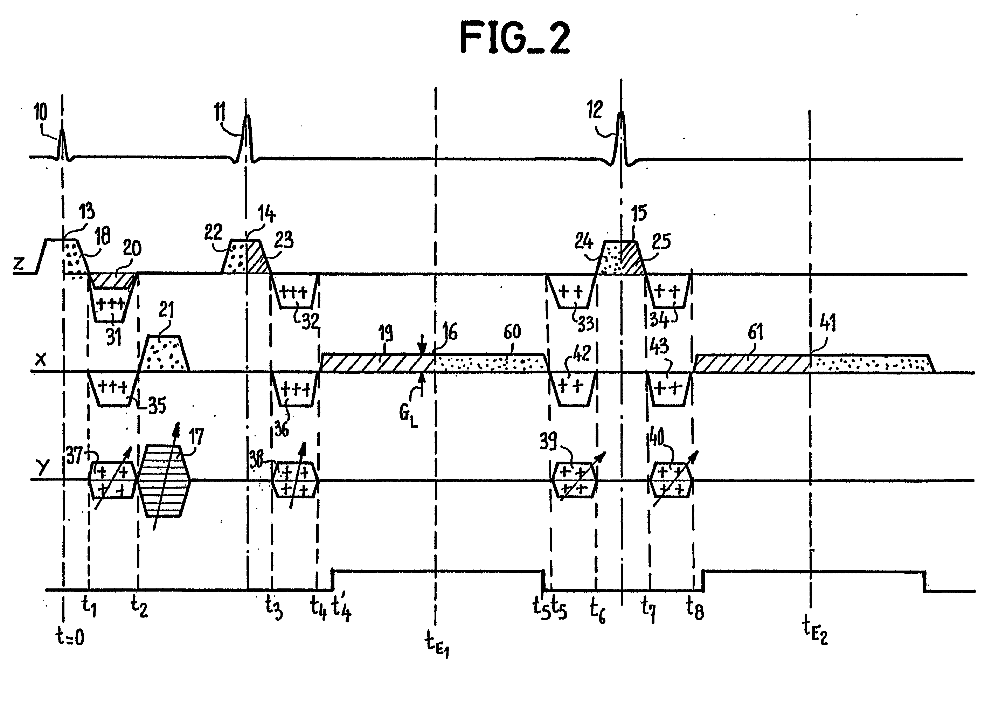

La figure 1 représente une machine utilisable pour mettre en œuvre le procédé de l'invention. Elle comporte des moyens symbolisés par une bobine 1 pour soumettre un corps 2 à un champ magnétique important et constant $B_0$. Le champ $B_0$ est le champ orientateur. La machine comporte encore des moyens générateurs 3 et bobines 4, reliés aux moyens générateurs 3, pour soumettre le corps ainsi placé à des séquences d'excitation radiofréquence en présence de séquences de champ perturbateur : des gradients de champ orientés selon trois axes de référence de la machine X, Y ou Z (figure 2). Les bobines 4 représentent en même temps les bobines radiofréquence et les bobines de gradient de champ. La machine comporte encore des moyens de réception 5, reliés aux bobines 4, pour recevoir le signal de résonance magnétique. Dans une application d'imagerie, des moyens 6 peuvent permettre de calculer et de mémoriser une première image $I_1$ et une deuxième image $I_2$ d'une coupe 7 du corps 2. Les deux images sont relatives à deux séries d'expérimentation imposées par des commandes symbolisées $C_1$ et $C_2$ des moyens générateurs 3. Dans des moyens de comparaison 8 on compare point à point les images $I_1$, $I_2$, et on élabore une troisième image $I_3$. On peut visualiser cette image $I_3$ sur un dispositif de visualisation 50.

Dans les images $I_1$, $I_2$, ou $I_3$, un point d'image, ou pixel $\underline{p}$, représente classiquement par sa luminosité la densité de particules contenue dans un élément de volume, ou voxel $\underline{v}$ qui lui correspond dans la tranche 7. Le voxel $\underline{v}$ comporte de nombreuses particules animées de vitesses V comportant des composantes $V_x$, $V_y$ et $V_z$ sur chacun des trois axes de référence de la machine. L'invention va permettre de calculer dans le voxel $\underline{v}$, et pour tous les autres voxels aussi, la vitesse moyenne et le nombre des particules de ce voxel ainsi en mouvement. L'image $I_3$ est représentative de cette information de vitesse, par comparaison entre deux images $I_1$ et $I_2$ où l'effet de cette vitesse aura été modulée de deux manières différentes.

Dans un premier temps, on va rappeler brièvement la théorie de l'imagerie par une méthode de type 2DFT. Dans cette méthode comme dans toutes les autres il existe des gradients perturbateurs. Dans un deuxième temps on va rappeler pourquoi cette méthode est préférée eu égard à des problèmes d'inhomogénéité du champ orientateur. Dans un troisième temps, on indiquera, dans cet exemple, comment se calculent les champs compensateurs nécessaires pour moduler l'effet de la vitesse.

Pour localiser une région d'un milieu il est nécessaire de repérer la nature de son émission en fonction de conditions locales de champ magnétique. Ces conditions locales sont imposées de façon à ce que la fréquence et la phase d'émission soient bien caractéristiques de la localisation dans l'espace de cette région du milieu. Pour cela on superpose au champ principal $B_0$ des gradients de champ magnétique pulsés. Ces gradients sont orientés selon des directions X, Y, Z pour définir à tout moment les éléments de volume qui résonnent à des fréquences connues. Pour l'acquisition d'une image entière les conditions locales sont imposées en des séquences programmées ($C_1$, $C_2$). Celles-ci sont mises en mémoire dans un ordinateur pilote. Ces séquences définissent les instants d'application des gradients, les instants d'excitation des particules par les impulsions du champ radiofréquence, ainsi que les instants de lecture ou d'acquisition des données de l'image.

La méthode d'imagerie 2DFT permet actuellement d'obtenir la meilleure qualité d'image. Dans cette méthode d'imagerie seul un plan de coupe, le plan 7 est, excité à la fois. La figure 2 montre à cet effet des impulsions radiofréquence 10, 11 et 12 appliquées en présence d'un gradient de champ dit de sélection, par exemple orienté selon l'axe Z, et représenté respectivement par des impulsions 13, 14 et 15. Quand le gradient de sélection est orienté selon l'axe Z la coupe est transverse, c'est-à-dire selon un plan X, Y. Dans l'imagerie 2 DFT on code en phase les différents signaux acquis. Ceci est obtenu par une impulsion d'intensité variable d'un gradient dit déphaseur, d'axe perpendiculaire à un gradient dit de lecture, dont la direction est constante. Par exemple, pour une coupe transverse, le gradient de lecture peut être sur l'axe X et le gradient de déphasage peut être sur l'axe Y. Sur la figure 2, le gradient X est coté 16, le gradient Y est coté 17. Par une double transformée de Fourier spatiale l'image est reconstruite, d'où le nom de la méthode. Une amélioration de cette méthode peut d'ailleurs permettre d'obtenir simultanément des images de plusieurs coupes parallèles.

L'existence du précodage 17, qui prend un certain temps, repousse dans le temps la mesure du signal émis par le corps. Comme ce signal s'atténue très vite, on a imaginé d'en mesurer un écho. Cet écho est produit, au moment de l'application des impulsions radiofréquence 11 puis 12 par une réflexion de la dispersion de phase des contributions apportées par chacune des particules. Pour cette raison ces impulsions sont dessinées sur la figure 2 plus hautes que l'impulsion 10 puisqu'elles font basculer l'orientation des moments magnétiques des spins des particules de 180° alors que l'impulsion 10 ne les avait fait basculer que de 90°. Pour imager une coupe d'un corps il y a lieu de réaliser des séquences d'excitation d'écho de spin en présence de séquences de gradients de champ en un nombre aussi important de fois que la résolution de l'image attendue doit être plus précise. A chaque séquence d'excitation, le gradient déphaseur Y varie par pas successifs partant d'une certaine valeur jusqu'à la même valeur mais de signe opposé. Cette valeur dépend de la forme et de la durée du gradient 16 de lecture. Ce gradient déphaseur permet de faire tourner chaque moment magnétique de spin d'une phase variable, dépendant de son ordonnée suivant l'axe Y et de la valeur de ce gradient. Pour chaque image $I_1$ et $I_2$ le gradient Y peut prendre successivement le même nombre de valeurs : d'une manière préférée la définition des deux images sera la même.

Pour éviter un précodage parasite imposé par la fin 18 de l'impulsion 13, pour la partie de cette impulsion existant après la fin de l'impulsion radiofréquence 10, et par le début 19 de l'impulsion 16 de lecture il est connu d'appliquer sur ces axes respectivement des impulsions 20 et 21. L'intégrale temporelle de ces impulsions est la même mais de signe opposé, elles neutralisent l'effet parasite de codage. L'intégrale est entendue au sens d'intégrale dans le temps. Les surfaces hachurées 20 et 19 sont donc égales aux surfaces en pointillés 18 et 21 respectivement. Les impulsions 20 et 21 n'interfèrent pas dans la sélection de coupe puisqu'au moment où elles sont appliquées l'impulsion 10 n'est plus présente. Les impulsions 14 et 15 sont autoneutralisées puisqu'elles comportent des portions respectivement 22 et 23, et 24 et 25 antisymétriques par rapport au milieu de l'impulsion radiofréquence, 11 et 12 pour lesquelles elles resélectionnent la coupe 7 dans le corps 2.

La méthode d'imagerie de type 2 DFT est la plus utilisée dans la pratique du fait de sa rapidité d'acquisition (comparée à des méthodes 3D) et à sa robustesse vis-à-vis des imperfections du système physique, en particulier vis-à-vis des inhomogénéités du champ orientateur. Ceci s'apprécie particulièrement en comparaison avec des méthodes par rétroprojection ou avec des méthodes n'utilisant pas d'écho de spin. Cette méthode est en contrepartie la plus intrinsèquement sensible au déplacement des particules. L'immunité aux inhomogénéités du champ $B_0$ de la méthode 2 DFT provient du fait que contrairement aux méthodes par rétroprojection le gradient codeur en fréquence est de même direction (le gradient de lecture X) et de même amplitude, $G_L$, d'une séquence à l'autre. L'inhomogénéité du champ $B_0$ ne fait alors que déformer les lignes isofréquences de résonance. Pendant la lecture du signal, l'inhomogénéité du champ devient l'équivalent d'une mauvaise linéarité du gradient de lecture. Les images sont en conséquence distordues mais sans la création de flou et sans la perte de résolution associées que l'on rencontre avec les méthodes par rétroprojection. Dans celles-ci en effet le gradient de lecture change d'orientation à chaque séquence et de ce fait il répartit les inhomogénéités du champ orientateur dans toute l'image pour laquelle il crée ainsi un flou.

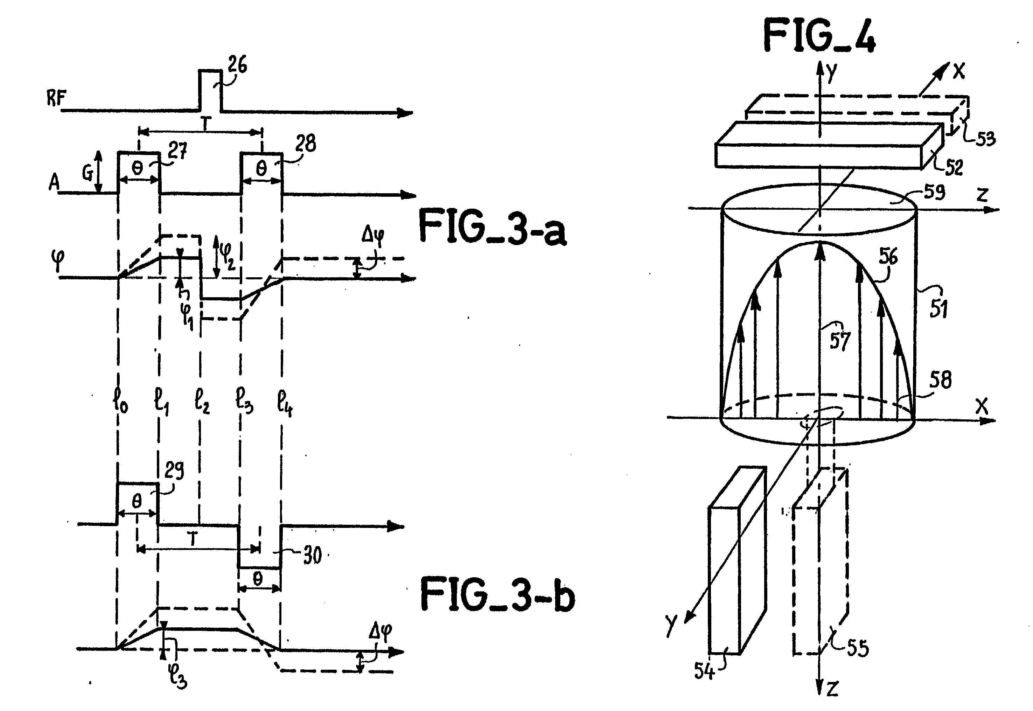

Les figures 3a et 3b montrent le déphasage $\Delta\phi$ résultant dans la contribution de signal émis par deux particules d'un même voxel soumises à des perturbations identiques, quand l'une des particules (trait plein) est immobile alors que l'autre particule (tirets) est animée d'une vitesse V. La figure 3a montre le diagramme temporel d'un signal radiofréquence RF comportant une impulsion 26 pour créer un écho de spin. Selon un axe A un gradient de champ magnétique a été imposé avant et après l'impulsion 26, par exemple, une valeur G pendant une durée $\theta$ à chaque fois. En un lieu donné $l_0$ une particule préalablement excitée, immobile, vibre à une fréquence $f_0$ au début de l'application de l'impulsion 27. Pendant la durée $\theta$ de cette impulsion 27 elle vibre à une fréquence différente. Par exemple cette fréquence est supérieure, de telle manière qu'à la fin de l'impulsion 27 on puisse considérer, puisqu'elle se remet à vibrer à la fréquence $f_0$ qu'elle a subi un déphasage $\phi_1$. Lors de l'application de l'impulsion radiofréquence 26 on peut admettre que tout se passe comme si la phase du signal émis par cette particule s'inversait : $-\phi_1$. Pendant l'impulsion 28 qui a exactement la même allure que l'impulsion 27 le phénomène de déphasage continue : la contribution se déphase encore de $\phi_1$. Mais ce dernier déphasage vient effacer l'effet du premier après qu'il ait été inversé par l'impulsion 26. En conséquence, la particule immobile en $l_0$ retrouve à la fin de l'impulsion 28 la phase qu'elle avait au début de l'impulsion 27. Il est utile de remarquer que le déphasage $\phi_1$ est proportionnel d'une part à l'amplitude du gradient G et d'autre part à la durée pendant laquelle chaque impulsion du gradient est imposée. Plus généralement $\phi_1$ est proportionnel à l'intégrale de ce gradient pendant la durée d'existence de son impulsion si cette impulsion n'est pas exactement carrée.

Il en va tout autrement pour une deuxième particule, toute voisine dans le même voxel de la particule précédente, et qui par contre est animée d'une vitesse V. Sur la figure 3a, on a indiqué que cette particule se trouvait successivement dans les positions $l_0$ à $l_4$ au début et à la fin de la première impulsion 27, au moment de l'impulsion radiofréquence 26, et au début et à la fin de la deuxième impulsion 28 du gradient. Après la première impulsion 27 de gradient, le déphasage résultant $\phi_2$ est proportionnel au gradient G et à la durée $\theta$. Mais il est aussi proportionnel à la distance $l_1 - l_0$ parcourue dans l'intervalle par la particule. Cette distance est égale à V. $\theta$ . Ce qui fait que le temps intervient maintenant au carré : la première portion de déphasage à l'allure d'une parabole (V.G.$\theta^2$). De la fin de l'impulsion 27 au début de l'impulsion 28, tout se passe comme pour la particule immobile : la contribution possède une phase $-\phi_2$ au début de l'impulsion 28. Au cours de cette impulsion 28 l'évolution de la phase est également parabolique comme pour l'impulsion 27. On pourrait s'attendre à ce que les effets de phase s'effacent ici également. Cependant entre la fin de l'impulsion 27 et le début de l'impulsion 28 la particule animée s'est déplacée de la position $l_1$ à la position $l_3$. Dans la position $l_3$ au moment où l'impulsion 28 apparaît, et du fait de l'existence du gradient de champ, les conditions locales de champ ne sont plus les mêmes que celles qui avaient prévalu quand la particule s'était trouvée entre $l_0$ et $l_1$. En conséquence à la fin de l'impulsion 28 la compensation ne s'opère pas et cette particule animée émet alors un signal déphasé d'une valeur $\Delta\phi$ que l'on peut écrire de la manière suivante :

$$\Delta\phi = \gamma. \, G(\theta). \, V.T.$$

où $\gamma$ est le rapport gyromagnétique des particules considérées, où $G(\theta)$ représente le gradient dans les impulsions 27 et 28, et où T est la durée qui sépare l'apparition de ces deux impulsions. Si $\theta$ n'est pas petit, T mesure la durée entre les milieux de ces impulsions. Plus généralement on peut écrire :

$$\Delta\phi(t) = V.\int_0^t \gamma . \, G(\tau). \, \tau . \, d\tau$$

où le déphasage est donné maintenant en fonction du temps et où $G(\tau)$ représente toutes les perturbations appliquées aux particules avant qu'on en mesure à une date $t$ le signal qu'elles émettent. On se souvient simplement que les perturbations considérées sont telles que :

$$\int_0^t G(\tau) \, d\tau = 0$$

Car c'est sous cette condition que, d'une manière connue dans l'état de la technique (figure 2 impulsions 18 à 25), on a compensé les précodages parasites. On ne l'avait bien entendu pas fait pour l'impulsion variable 17 puisque le déphasage qu'elle provoque pour le signal global est, d'une acquisition à l'autre, une des caractéristiques permettant l'imagerie.

En l'absence d'une impulsion radiofréquence telle que 26 créant un écho de spin (figure 3b), les impulsions 27 et 28 du gradient bipolaire doivent être remplacées par des impulsions 29, 30 de signes opposés. De cette manière la phase pour les particules fixes évolue jusqu'à $\phi_3$ en fin de l'impulsion 29 et évolue en sens inverse jusqu'à zéro au cours de l'impulsion inverse 30. Le déphasage $\Delta\phi$ entre la contribution des particules mobiles et celles des particules fixes est du même ordre que précédemment.

Dans l'expression de $\Delta\phi(t)$, $G(\tau)$ représente donc toutes les séquences nécessitées par la mesure. Ce qui caractérise l'invention c'est que ces séquences sont maintenues telles quelles mais que leurs effets sur la vitesse sont compensés par l'adjonction de séquences supplémentaires de gradients de champ G' dits compensateurs tels que

$$\int_0^t (G(\tau).\tau + G'(\tau).\tau) \, d\tau = 0$$

où G' représente des gradients, eux aussi bipolaires, c'est-à-dire tels que

$$\int_0^t G'(\tau) \, d\tau = 0$$

Autrement dit, en agissant ainsi on annule le coefficient multiplicateur de la vitesse V qui apparaît dans le calcul de $\Delta\phi(t)$. Du coup, quelle que soit cette vitesse, $\Delta\phi(t)$ est nul : toutes les contributions sont en phase. Les particules mobiles sont prises en compte comme si elles étaient fixes.

En revenant à la figure 2 on voit sur chaque axe X, Y, Z l'adjonction de tels gradients bipolaires compensateurs sous la forme préférée de couples d'impulsions notés 31 et 32, 33 et 34, 35 et 36, 37 et 38, 39 et 40 et 42 et 43. L'incidence de ces impulsions compensatrices est symbolisée dans le dessin par la présence de petites croix. On sait, dans les machines de l'état de la technique imposer de telles impulsions en modifiant les commandes $C_1$ ou $C_2$ des moyens générateurs. L'intégrale dans le temps des impulsions de chaque couple est nulle. D'une manière préférée, puisque l'impulsion de correction de précodage 20 sur l'axe de sélection Z est appliquée entre des dates $t_1$ et $t_2$ à la fin de l'impulsion 13, on applique l'impulsion 31 pendant la même période.

Dans ce cas l'impulsion 20 "nouvelle" est plus forte. Les impulsions 35 et 37 sont également appliquées pendant cette période. Les impulsions 32, 36 et 38 d'une manière préférée sont appliquées entre la fin t₃ de l'impulsion 14 et le début t₄ de l'impulsion de lecture 16. Les impulsions 33, 39 et 42 sont appliquées entre la fin t₅ de l'impulsion 16 et le début t₆ de l'impulsion 15. Les impulsions 34, 40 et 43 sont appliquées entre la fin t₇ de l'impulsion 15 et le début t₈ d'une impulsion 41 qui sert à la lecture d'un deuxième écho.

Sur le plan pratique, la mesure du signal émis est effectuée entre des dates t'₄ et t'₅ contenues entre les dates t₄ et t₅ et aussi pendant la durée de l'impulsion 41. Bien entendu les impulsions de compensation appliquées sur un axe, X, Y ou Z ont pour objet d'effacer l'effet des gradients perturbateurs appliqués sur le même axe. L'expression intégrale donne implicitement les gradients G' ; il est possible de faire des simplifications. Premièrement tous les termes en $G(\tau).\tau$ sont des termes connus (ils appartiennent à la séquence 2DFT) : leur intégrale l'est également. Cette intégrale peut donc être sortie de l'expression. D'une manière préférée les formes des impulsions compensatrices 31 à 43 seront des formes connues et, dans la mesure du possible, identiques à des formes déjà pratiquées pour les impulsions normales des séquences perturbatrices. Compte tenu des dates retenues pour l'application de ces impulsions, une intégrale unitaire de chacune d'elle peut être calculée et l'expression de G' peut s'écrire d'une autre manière :

$$\int_0^t G(\tau).\tau.d\tau + \lambda \int_0^t \Gamma(\tau).\tau d\tau = 0$$

Le premier membre est connu il concerne les gradients perturbateurs. Le deuxième membre comporte des intégrales de gradients de forme préférée Γ et d'amplitude unité. On sait calculer l'intégrale du deuxième membre puisqu'on connaît la forme choisie Γ. En conséquence on peut en déduire λ c'est-à-dire l'amplitude des impulsions compensatrices.

Dans le cas de l'imagerie conventionnelle, où un gradient au moins est appliqué pendant la période de lecture (t'₄ , t'₅), l'équation implicite contenant G' ne peut être vérifiée pour tout t. Mais on doit au moins la vérifier aux temps t$_{E1}$, t$_{E2}$... centre des phases de mesure. Ces dates sont celles où l'écho de spin attendu est le plus fort. Elles sont telles que la durée séparant la date de l'impulsion radiofréquence 10 et t$_{E1}$ est le double de la durée entre l'impulsion 10 et l'impulsion 11, et telles que la durée entre la date t$_{E1}$ et la date t$_{E2}$ est égale au double de la durée entre la durée t$_{E1}$ et la date de l'impulsion radiofréquence 12.... La justification de ces dates est, d'une part, intuitive et, d'autre part, théorique. L'idée conductrice en ce domaine est que l'on cherche à connaître l'état de la coupe 7 non pas au moment de son excitation (impulsion 10) mais au moment, t$_{E1}$ ou t$_{E2}$ où justement on effectue la mesure : au centre du signal émis.

Tous les termes de l'équation implicite donnant G' étant connus, G' est calculable. Sur la figure 2 on va donner une approche simple de ce calcul. Pour l'axe X on sait que les impulsions 21 et 19 situées de part et d'autre de l'impulsion radiofréquence 11 neutralisent mutuellement leurs effets de précodage : l'intégrale de la somme de ces impulsions est nulle. Par contre l'intégrale du produit de ces impulsions par la durée qui les sépare de la date du relevé, t$_{E1}$, n'est pas nulle : l'impulsion 21 étant plus antérieure dans le temps que l'impulsion 19. Tout se passe donc comme si l'impulsion 21 de "force" donnée est appliquée à un "bras de levier" plus long que l'impulsion 19 de force égale. L'effet sur la phase de l'impulsion 19 est bien entendu inverse de celui de l'impulsion 21 puisqu'elles sont situées de part et d'autre de l'impulsion 11. En conséquence leur effet commun sur la phase s'analyse comme un moment orienté dans le sens de l'impulsion ayant le plus grand bras de levier : l'impulsion 21. Il convient de contrecarrer ce moment résultant par un couple d'impulsions 35, 36 dont l'intégrale totale est nulle (il ne provoque aucun déphasage sur le signal des parties fixes) mais dont le moment global s'oppose au moment global des deux impulsions 21 et 19. Ainsi, l'impulsion 35 étant placée dans le temps à une date plus antérieure que l'impulsion 36 par rapport à la date t$_{E1}$ son effet est prépondérant. Il est bien de sens opposé à l'impulsion 21.

De la même façon sur l'axe de sélection Z, des impulsions 18 et 20, et 22 et 23, ce sont à chaque fois les impulsions 18 et 22 qui priment : leur bras de levier est plus long. En conséquence on conçoit bien que l'impulsion 31 doit être dans le même sens que l'impulsion 20. Le cas des impulsions 37 et 38 est un peu différent. En effet elles doivent contrecarrer les effets d'un gradient qui varie d'une acquisition à l'autre. Les amplitudes des impulsions 37 et 38 varieront donc également en correspondance d'une acquisition à l'autre (symbolisé par des flèches). Pour les raisons précédentes quand l'impulsion 17 est positive l'impulsion 37 doit être négative. Pour pouvoir réduire les amplitudes des impulsions compensatrices on cherche bien entendu à donner à leur moment le plus d'efficacité possible : on essaie d'augmenter la durée qui sépare leur application de la date du relevé. On les place le plus en amont possible de la séquence pour la première (31, 35, 37) et le plus en aval pour la deuxième (32, 36, 38). En conclusion elles sont le plus éloignées possible de part et d'autre de l'impulsion radiofréquence 11 ; et elles sont le plus éloignées possible l'une de l'autre.

Lors du premier relevé, en t$_{E1}$, les effets de vitesse des parties mobiles ont été complètement compensés. On compense maintenant au moyen des impulsions 33 et 34 les effets de la deuxième impulsion de sélection 15. La date pivot pour le calcul des moments est maintenant la date t$_{E2}$. Sur l'axe de lecture X on compense également par deux impulsions 42 et 43 les effets de la deuxième moitié 60 de l'impulsion 16 et de la première moitié 61 de l'impulsion 41. La présence des impulsions compensatrices 39 et 40 sur l'axe Y se justifie par le fait que l'impulsion 17 n'est pas bipolaire. Car la compensation de son moment à la date pivot $t_{E_1}$ par les impulsions 37 et 38 n'implique pas une telle compensation à une autre date pivot telle que $t_{E_2}$. Et ceci bien qu'aucune impulsion supplémentaire de perturbation n'intervienne sur cet axe entre-temps.

La figure 4 représente un tube d'écoulement 51 sensé se trouver dans la tranche examinée 7 du corps 2. Le haut de la figure représente une situation dans laquelle l'axe du tube 51 est situé dans le plan X, Y de la coupe. Dans la partie basse de la figure la situation est différente : le tube 51 est supposé être perpendiculaire au plan X et Y de la coupe. De part et d'autre sont représentés des voxels notés 52 à 55. Ces voxels ont la forme de parallélépipèdes rectangles ayant une forme de section sensiblement carrée. La section est carrée dans la mesure où, dans l'imagerie, l'échantillonnage représentatif est effectué avec la même résolution selon l'axe X et l'axe Y du plan de coupe. La grande longueur du parallélépipède rectangle s'étend selon l'axe Z. Cette longueur est liée à l'épaisseur de la coupe 7. Cette épaisseur est un compromis expérimental entre la finesse de résolution des coupes et la quantité de signal global mesurable. Plus la coupe est épaisse plus le signal mesurable est élevé, et bien entendu moins l'image est précise. Dans la pratique la grande dimension est de l'ordre de 7 à 15 mm, la section carrée est de l'ordre de 1 mm par 1 mm.

Dans le conduit 51 un fluide non représenté circule avec un diagramme de vitesse 56. Les vitesses 57 des particules situées au centre sont plus élevées que les vitesses 58 des particules situées sur les bords du conduit. Dans les artères la vitesse 57 peut être de l'ordre de 50 cm par seconde. Les voxels 52 et 53 comportent, quand ils sont situés à l'aplomb de la section 59 du conduit 51, nécessairement des particules animées avec des vitesses très différentes. Avant l'invention l'étalement du spectre de vitesse était tellement important que la contribution des voxels 52 et 53 dans le signal global était nulle : on avait l'impression que le tube était creux. L'image des voxels 54 et 55 pouvait dans certains cas être révélatrice. Elle l'était dans la mesure où ces voxels se situaient à l'aplomb de la partie de la section du conduit où l'étalement du spectre des vitesses était faible. C'est le cas pour le voxel 55 où les vitesses (au centre du tube) tout en étant élevées sont relativement homogènes entre elles. Leur déphasage correspondant est sensiblement le même: la moyenne n'est pas nulle. Par contre pour le voxel 54 situé à l'aplomb du bord du conduit 51, là où l'évolution des vitesses est brutale, le signal restitué est nul. Il en résultait que l'image des tubes 51 perpendiculaires au plan de coupe était appréciée géométriquement plus petite qu'elle n'était en réalité. Avec l'invention l'image des écoulements est révélée fidèlement.

On peut moduler l'effet de la vitesse avec le procédé de l'invention. Il suffit de ne pas annuler totalement le coefficient multiplicateur de V dans l'expression de $\Delta\phi(t)$ où les gradients compensateurs sont présents. Dans l'invention on propose de réaliser une deuxième expérimentation dans laquelle la compensation n'est plus complète et dans laquelle en définitive la mesure est sensible à cet effet de vitesse. On compare ultérieurement les résultats obtenus au cours de ces deux expérimentations. On en déduit les caractéristiques de vitesse recherchées. D'une manière préférée on fera varier la modulation selon un axe particulier. Cet axe particulier peut être l'axe X, l'axe Y, l'axe Z, ou même un axe différent. Pour faire varier cette modulation on modifie l'amplitude ($\lambda$) des impulsions de compensation appliquées respectivement sur les axes X, Y, Z ou sur une combinaison de ces axes.

Dans la deuxième expérimentation on s'arrange pour que la sensibilité à l'effet de vitesse soit telle que, pour la vitesse nominale attendue à mesurer, l'écart maximal de phase soit de l'ordre de ou inférieur à un radian. Dans ces conditions on peut montrer que l'information de vitesse est obtenue simplement en calculant le rapport de la variation relative des mesures, d'une expérience à l'autre, à la mesure de la première (ou de la deuxième) expérience. Autrement dit si $S_1$ est le résultat de la première expérience, et si $S_2$ est le résultat de la deuxième, l'information de vitesse moyenne est représenté par $(S_1 - S_2)/S_1$. Au-delà de cette sensibilité d'une part le calcul proposé n'est plus applicable tel quel pour connaître l'information de vitesse, et d'autre part la sensibilité risque d'être tellement forte qu'on retomberait dans les difficultés que l'invention a résolues. C'est un calcul de ce type qu'effectuent les moyens de comparaison 8. Le calcul est entrepris pixel par pixel. D'une expérimentation à l'autre la sensibilité est passée de zéro à une certaine valeur calculable par l'intégrale de $G(\tau).\tau$ et de $G'(\tau).\tau$. On peut donc quantifier la vitesse mesurée.

Dans une variante préférée l'invention est mise en œuvre dans une méthode d'excitation avec écho de gradient. Cette méthode est préférée à une méthode avec écho de spin comme décrit jusqu'ici. En effet dans une méthode avec écho de spin, l'impulsion radiofréquence qui fait basculer de 180° les moments magnétiques des particules a une bande en fréquence légèrement surévaluée, redondante (de durée plus courte), pour bien rephaser les contributions de toutes les particules qui étaient entrées en résonance à cause de l'impulsion à 90°. Cette redondance peut provoquer en elle-même l'excitation parasite de particules voisines de la tranche 7. Or maintenant avec la compensation, ces particules voisines peuvent être codées (par l'impulsion 38 ou 40). Donc le signal parasite qu'elles produisent peut varier d'une séquence à l'autre. Dans ces conditions, on ne sait plus l'extraire du signal utile. S'il reste constant en effet, en faisant une double acquisition, on peut le supprimer. S'il n'est pas supprimé sa présence peut être gênante.

Dans une séquence avec écho de gradient (figure 2) l'impulsion radiofréquence 11 (et 12...) est supprimée. L'impulsion 14 de deuxième sélection n'a plus lieu d'exister. L'impulsion 21 d'équilibrage de l'impulsion de lecture 16 est de sens opposé. L'impulsion 17 est inchangée. L'écho de gradient est provoqué par l'égalité des aires 21 (inversée) et 19. Dans ces conditions les gradients perturbateurs ont tous des allures comparables à ceux de la figure 3b. On les compense néanmoins selon le même principe que pour ceux de la figure 3a. Pour la compensation du gradient de codage de phase les impulsions de compensation 37 et 38 sont maintenues telles quelles. Comme il n'y a plus d'écho de spin il ne peut plus y avoir de signal parasite que l'on ne saurait pas éliminer.

**Revendications**

1. Procédé de modulation de l'effet de la vitesse de parties mobiles d'un corps (2) dans une mesure de densité par résonance magnétque nucléaire, mesure pour laquelle
   - on soumet le corps (2) à un champ magnétique orientateur ($B_0$) constant pour orienter dans une direction unique (Z) des moments magnétiques de spin du corps (2),
   - on fait subir à ce corps (2) une excitation magnétique grâce à une première impulsion de radiofréquence (10) en présence de et/ou suivie de l'application d'une séquence d'un champ magnétique perturbateur (13, 14, 17),
   - et on relève un signal radiofréquence émis en réponse par le corps (2),
   - procédé dans lequel on module l'effet de la vitesse (V) des parties mobiles du corps créé par la séquence du champ perturbateur par l'application, avant le relevé ($t_{E1}$), d'une séquence d'impulsions (31–43) d'un champ magnétique compensateur dont l'intégrale calculée sur sa durée est nulle, et dont l'historique et la valeur sont fonction de l'historique et la valeur du champ perturbateur, les impulsions de champ magnétique compensateur étant déterminées a priori en forme ($\Gamma$), en durée, et en position ($t_1–t_2$), et leur amplitude ($\Lambda$) étant évaluée pour obtenir la modulation recherchée.

2. Procédé selon la revendication 1, selon lequel la séquence du champ magnétique perturbateur comporte des impulsions de champ magnétique selon trois axes orthogonaux (X, Y, Z), et la séquence du champ magnétique compensateur comporte des impulsions de champ magnétique selon ces trois mêmes axes, pour moduler un à un les effets de la vitesse des parties mobiles du corps selon ces trois mêmes axes.

3. Procédé selon la revendication 1 ou 2, selon lequel la séquence des champs magnétiques compensateurs comporte des couples bipolaires d'impulsions.

4. Procédé selon la revendication 1, 2, ou 3 dans lequel la séquence des champs magnétiques compensateurs comporte des couples d'impulsions, chaque impulsion d'un couple étant de valeur, de forme, de durée, et signe égal à l'autre impulsion du couple, et ces impulsions se trouvant respectivement avant et après une deuxième impulsion de radiofréquence.

5. Procédé selon l'une quelconque des revendications 1 à 4, dans lequel l'intégrale du produit de la valeur des impulsions de champ perturbateur par la durée qui les sépare du relevé du signal émis est compensée par l'intégrale d'un même produit obtenu avec les impulsions de champ compensateur.

6. Procédé selon la revendication 3 ou 4, dans lequel les impulsions des couples d'impulsions comportent des impulsions les plus éloignées possible l'une de l'autre.

7. Procédé selon l'une quelconque des revendications 1 à 6, dans lequel l'excitation magnétique radiofréquence comporte une première impulsion (10) radiofréquence pour faire basculer de 90° l'orientation des moments magnétiques des spins, suivie d'au moins une deuxième (11) impulsion magnétique radiofréquence pour faire basculer de 180° l'orientation des moments magnétiques des spins, et dans lequel l'on relève ($t_{E1}$) comme signal de résonance magnétique l'écho du signal émis en réponse après qu'il ait été réfléchi par la deuxième impulsion (11) radiofréquence.

8. Procédé selon l'une quelconque des revendications 1 à 6, dans lequel l'excitation magnétique radiofréquence comporte une première impulsion (10) radiofréquence pour faire basculer de 90° l'orientation des moments magnétiques des spins, suivie d'une première impulsion (29) d'écho de gradient et l'on relève comme signal de résonance magnétique l'écho du signal émis en réponse après qu'il ait été réfléchi par une deuxième impulsion (30) de gradient.

9. Procédé selon l'une quelconque des revendications 1 à 8, dans lequel la mesure comporte la production de l'image d'un volume dont la position et les dimensions sont déterminées par la séquence (13–15) du champ magnétique perturbateur.

10. Procédé selon l'une quelconque des revendications 1 à 8, dans lequel la mesure comporte la production (6) d'une image d'une coupe (7) du corps dont la position dans le corps est déterminée par la séquence (13–15) du champ magnétique perturbateur.

11. Procédé selon la revendication 9, dans lequel la production de l'image est accomplie selon un procédé de type transformée de Fourier inverse à trois dimensions (3DFT).

12. Procédé selon la revendication 7, dans lequel la production de l'image est accomplie selon un procédé de type transformée de Fourier inverse à deux dimensions (2DFT).

13. Mise en œuvre du procédé selon l'une quelconque des revendications 1 à 12, selon laquelle on le met en œuvre une première fois ($I_1$) pour compenser l'effet de la vitesse, et une autre fois ($I_2$) en modifiant une ou plusieurs des caractéristiques du champ magnétique compensateur, et l'on compare (8, $I_3$) les mesures obtenues dans les deux mises en œuvres pour en déduire la vitesse des parties mobiles concernées.

14. Mise en œuvre selon la revendication 13, lorsque celle-ci concerne la mise en œuvre du procédé selon l'une quelconque des revendications 2 à 12, selon laquelle la modification porte sur de caractéristiques du champ magnétique compensateur relative à un axe pour en déduire la composante de vitesse des parties mobiles selon cet axe.

15. Mise en œuvre selon la revendication 13 ou la revendication 14, selon laquelle la modification est telle que le déphasage ($\Delta \varphi(t)$) correspondant sur le signal émis par les parties mobiles se déplaçant à une vitesse nominale est de l'ordre de 1 radian.

## Claims

1 A method for the modulation of the effect of velocity of mobile parts of a body (2) during an operation measuring density by nuclear magnetic resonance, for which measuring operation
- the body (2) is submitted to a constant orientating magnetic field ($B_0$) in order to orientate magnetic spin moments of the body (2) in a single direction (Z),
- the body (2) is subjected to magnetic excitation due to a first radiofrequency pulse (10) in the presence of and/or followed by the application of a sequence of magnetic disturbing field (13, 14 and 17),
- a detecting a radiofrequency signal emitted by the body in response, in which method one modulates the effect of velocity (V) of mobile parts of the body created by the sequence of the disturbing field by the application, prior to detection ($t_{E1}$), of a sequence (31 - 43) of pulses of a compensating magnetic field, whose integral with respect to duration is zero, and whose history and value are a function of the history and value of the disturbing field, the pulses of the compensating magnetic field being determined in form ($\Gamma$), in duration, and in position ($t_1 - t_2$) and the amplitude ($\lambda$) thereof being evaluated in order to obtain the desired modulation.

2 The method as claimed in claim 1 in accordance with which the sequence of the disturbing magnetic field comprises magnetic field pulses on three orthogonal axes (X, Y and Z) and the sequence of the compensating magnetic field comprises magnetic field pulses on these three same axes, in order to modulate one by one the effects of velocity of the mobile parts of the body on these same three axes.

3 The method as claimed in claim 1 or claim 2 in accordance with which the sequence of the magnetic compensating fields comprises bipolar pulse couples.

4 The method as claimed in any one of the preceding claims 1, 2 and 3, wherein the sequence of compensating magnetic fields comprises pulse couples, each pulse of a couple being in value, in form, in duration and in sign equal to the other pulse of the couple, such pulses respectively coming before and after a second radiofrequency pulse.

5 The method as claimed in any one of the preceding claims 1 through 4, in which the integral of the product of the value of the pulses of the disturbing field and the duration of time separating them from the detection of the signal emitted is compensated by the integral of the same product obtained with the pulses of the compensating field.

6 The method as claimed in claim 3 or claim 4, wherein the pulses of the pulse couples comprise pulses which are furthest apart from each other.

7 The method as claimed in any one of the preceding claims 1 through 6, wherein the radiofrequency magnetic excitation comprises a first radiofrequency pulse (10) in order to cause a 90° swing of the orientation of the magnetic spin moments, followed by at least a second (11) radiofrequency magnetic pulse to cause a swing of 180° of the magnetic moments of the spings, and in which one detects ($t_E$) as the magnetic resonance signal the echo of the signal emitted in response after it has been reflected by the second radiofrequency pulse (11).

8 The method as claimed in any one of the preceding claims 1 through 6, wherein the radiofrequency magnetic excitation comprises a first radiofrequency pulse (10) in order to cause a 90° swing of the orientation of the magnetic spin moments, followed by a first echo gradient pulse (29) and one detects as a magnetic resonance signal the echo of the signal emitted in response after it has been reflected by a second gradient pulse (30).

9 The method as claimed in any one of the preceding claims 1 through 8, wherein the measuring operation comprises the production of the image of a volume whose position and whose dimensions are determined by the sequence (13 - 15) of the disturbing magnetic field.

10 The method as claimed in any one of the preceding claims 1 through 8, wherein the measuring operation comprises the production (6) of an image of a section of a section (7) of the body whose position within the body is determined by the sequence (13 - 15) of the disturbing magnetic field.

11 The method as claimed in claim 9, wherein the production of the image is performed using a method of the inverse Fourier transformation type with three dimensions (3DFT).

12 The method as claimed in claim 7, wherein the production of the image is performed using a method of inverse Fourier transformation type with two dimensions (2DFT).

13 The performance of the method as claimed in any one of the preceding claims 1 through 12, wherein said method is performed a first time ($I_1$) in order to compensate for the effect of velocity, and a second time ($I_2$) modifying one or more of the characteristics of the compensating magnetic field, and the readings are compared (8 and $I_3$) which are obtained during such operations in order to deduce the velocity of the mobile pits concerned.

14 The performance of the method as claimed in claim 13, when same relates to the performance of the method in accordance with one of the claims 2 through 12, in accordance with which the modification relates to characteristics of the compensating magnetic field relative to one axis in order to deduce therefrom the velocity component of the mobile parts on this axis.

15 The performance of the method as claimed in claim 13 or in the claim 14, wherein the modification is such that the corresponding phase offset ($\Delta\varphi(t)$) with respect to the signal emitted by the mobile parts moving at a nominal velocity is of the order of one radian.

## Patentansprüche

1. Verfahren für die Modulation der. Auswirkung der Geschwindigkeit der beweglichen Teile eines Körpers (2) in einer Dichtemessung mittels magnetischer Kernresonanz, eine Messung, für die
- der Körper (2) einem konstanten magnetischen Orientierungsfeld ($B_0$) unterzogen wird, um magnetische Spinmomente des Körpers (2) in eine einzige Richtung (Z) auszurichten,
- der Körper (2) einer magnetischen Erregung aufgrund eines ersten Funkfrequenzimpulses (10) bei Vorhandensein und/oder gefolgt von der Anwendung einer Folge eines magnetischen Störfeldes (13, 14, 17) unterzogen wird,
- und ein als Reaktion vom Körper (2) gesendetes Funkfrequenzsignal abgelesen wird.
- Verfahren, in dem die durch die Folge des Störfeldes entstandene Auswirkung der Geschwindigkeit (V) der beweglichen Teile des Körpers durch die vor der Ablesung ($t_{E1}$) erfolgende Anwendung einer Impulsfolge (31-43) eines magnetischen Ausgleichsfeldes moduliert wird, dessen über seine Dauer berechnetes Integral Null beträgt, und dessen Werdegang und Wert vom Werdegang und Wert des Störfeldes abhängen, wobei die magnetischen Ausgleichsfeldimpulse von vornherein in Form ($\Gamma$), Dauer und Lage ($t_1 - t_2$) ermittelt werden und ihre Amplitude ($\lambda$) abgeschätzt wird, um die gesuchte Modulation zu erreichen.

2. Verfahren nach Anspruch 1, nach dem die Folge des magnetischen Störfeldes magnetische Feldimpulse entlang drei orthogonaler Achsen (X, Y, Z) umfaßt und die Folge des magnetischen Ausgleichsfeldes magnetische Feldimpulse entlang dieser drei gleichen Achsen umfaßt, um nacheinander die Auswirkungen der Geschwindigkeit der beweglichen Teile des Körpers entlang dieser drei gleichen Achsen zu modulieren.

3. Verfahren nach Anspruch 1 oder 2, nach dem die Folge der magnetischen Ausgleichsfelder bipolare Impulspaare umfaßt.

4. Verfahren nach Anspruch 1, 2 oder 3, in dem die Folge der magnetischen Ausgleichsfelder Impulspaare umfaßt, wobei jeder Impuls eines Paares im Wert, in der Form, in der Dauer und im Vorzeichen dem anderen Impuls des Paares gleich ist, und sich diese Impulse jeweils vor und nach einem zweiten Funkfrequenzimpuls befinden.

5. Verfahren nach einem der Ansprüche 1 bis 4, in dem das Integral des Produkts aus dem Wert der Störfeldimpulse und der Dauer, die sie von der Ablesung des gesendeten Signals trennt, durch das Integral eines gleichen mit den Ausgleichsfeldimpulsen erhaltenen Produkts kompensiert wird.

6. Verfahren nach Anspruch 3 oder 4, in dem die Impulse der Impulspaare Impulse umfassen, die so weit wie möglich voneinander entfernt sind.

7. Verfahren nach einem der Ansprüche 1 bis 6, in dem die magnetische Funkfrequenzerregung einen ersten Funkfrequenzimpuls (10) umfaßt, um die Orientierung der magnetischen Spinmomente um 90° kippen zu lassen, dem wenigstens ein zweiter (11) magnetischer Funkfrequenzimpuls folgt, um die Orientierung der magnetischen Spinmomente um 180° kippen zu lassen, und in dem das Echo des als Reaktion gesendeten Signals als magnetisches Resonanzsignal abgelesen wird ($t_{E1}$), nachdem es vom zweiten Funkfrequenzimpuls (11) reflektiert worden ist.

8. Verfahren nach einem der Ansprüche 1 bis 6, in dem die magnetische Funkfrequenzerregung einen ersten Funkfrequenzimpuls (10) umfaßt, um die Orientierung der magnetischen Spinmomente um 90° kippen zu lassen, dem ein erster Gradientechoimpuls (29) folgt, und das Echo des als Reaktion abgesendeten Signals als magnetisches Resonanzsignal abgelesen wird, nachdem es von einem zweiten Gradientimpuls (30) reflektiert worden ist.

9. Verfahren nach einem der Ansprüche 1 bis 8, in dem die Messung die Erzeugung des Bildes von einer Größe umfaßt, deren Lage und Abmessungen von der Folge (13 - 15) des magnetischen Störfeldes bestimmt werden.

10. Verfahren nach einem der Ansprüche 1 bis 8, in dem die Messung die Erzeugung (6) eines Bildes von einem Schnitt (7) des Körpers umfaßt, dessen Lage im Körper von der Folge (13 - 15) des magnetischen Störfeldes bestimmt wird.

11. Verfahren nach Anspruch 9, in dem die Erzeugung des Bildes nach einem Verfahren vom Typ der inversen dreidimensionalen Fourier-Transformation (3DFT) erzielt wird.

12. Verfahren nach Anspruch 7, in dem die Erzeugung des Bildes nach einem Verfahren vom Typ der inversen zweidimensionalen Fourier-Transformation (2DFT) erzielt wird.

13. Durchführung eines Verfahrens nach einem der Ansprüche 1 bis 12, gemäß dem das Verfahren ein erstes Mal ($I_1$) durchgeführt wird, um die Auswirkung der Geschwindigkeit zu kompensieren, und ein weiteres Mal ($I_2$), indem eine oder mehrere der Kenngrößen des magnetischen Ausgleichsfeldes abgeändert werden und die bei den zwei Durchführungen erhaltenen Messungen verglichen (8, $I_3$) werden, um davon die Geschwindigkeit der betroffenen beweglichen Teile abzuleiten.

14. Durchführung nach Anspruch 13, wenn diese die Durchführung des Verfahrens nach einem der Ansprüche 2 bis 12 betrifft, gemäß der sich die Abänderung auf Kenngrößen des magnetischen Ausgleichsfeldes in bezug auf eine Achse erstreckt, um davon die Geschwindigkeitskomponente der beweglichen Teile entlang dieser Achse abzuleiten.

15. Durchführung nach Anspruch 13 oder Anspruch 14, gemäß der die Abänderung so ist, daß die entsprechende Phasenverschiebung ($\Delta\varphi(t)$) des Signals, das von den sich mit Nenngeschwindigkeit verlagernden beweglichen Teilen gesendet wird, von der Größenordnung 1 im Bogenmaß ist.

FIG_1

# FIG_2

EP 0 216 657 B1

FIG_4

FIG_3-a

FIG_3-b